# EUROPÄISCHE PATENTSCHRIFT

(11) **EP 2 846 369 B1**
(45) Veröffentlichungstag und Bekanntmachung des Hinweises auf die Patenterteilung: **28.12.2016**
(21) Anmeldenummer: 14180145.6
(22) Anmeldetag: 07.08.2014
(51) Int. Cl.: H01L 41/047, F02M 51/06

(54) **Außenelektrode für einen piezoelektrischen Aktor**
External electrode for a piezoelectric actuator
Électrode extérieure pour un actionneur piézoélectrique

(30) Priorität: 22.08.2013 DE 102013216666
(43) Veröffentlichungstag der Anmeldung: 11.03.2015
(73) Patentinhaber: Robert Bosch GmbH, 70442 Stuttgart (DE)
(72) Erfinder: Buhr, Kai, Charleston, 294182906 (US); Benes, Jan, 96047 Bamberg (DE)

(56) Entgegenhaltungen:
- WO-A1-2010/020643
- WO-A2-2004/019423
- DE-A1-102010 042 969

## Beschreibung

### Stand der Technik

Die Erfindung betrifft eine Außenelektrode für ein Vielschichtbauteil, ein piezokeramisches Vielschichtbauteil und ein Brennstoffeinspritzventil. Speziell betrifft die Erfindung das Gebiet der Injektoren für Brennstoffeinspritzanlagen von Brennkraftmaschinen.

Aus der DE 103 27 902 A1 ist eine Außenelektrode an einem piezokeramischen Vielschichtaktor bekannt. Hierbei besteht die bekannte Außenelektrode aus zwei Lagen eines leitenden Werkstoffs und einer dazwischen angeordneten Lage eines nicht leitenden Werkstoffs. Von den beiden leitenden Lagen ist die eine mit der Grundmetallisierung des Aktors verbunden und die andere ist mit einer Zuleitung für die Spannung verbunden. Die beiden leitenden Lagen sind leitend miteinander verbunden. Die Verbindung mit der Zuleitung kann entweder durch Löten oder durch Schweißen erfolgen.

Die aus der DE 103 27 902 A1 bekannte Außenelektrode, die an dem piezokeramischen Vielschichtaktor angebracht ist, hat den Nachteil, dass die Festigkeit der Verbindung und/oder die Leitfähigkeit der Verbindung begrenzt sind. Wird die Zuleitung angelötet, dann ergibt sich insbesondere eine begrenzte Festigkeit. Wird die Zuleitung hingegen angeschweißt, dann ergibt sich insbesondere eine schlechtere Leitfähigkeit.

Ein weiteres Beispiel ist aus der WO2010/020643 bekannt. Denkbar ist es, dass eine Schweißverbindung zwischen einer Zuleitung und einer Lage durch Lot ergänzt und verbessert wird. Hierdurch können insbesondere die Zuverlässigkeit der elektrischen Leistungsübertragung und die mechanische Haftung verbessert werden. Die verbindungsrelevante Lotmenge kann hierbei über die äußere Lage der Außenelektrode und beispielsweise einen Pin der elektrischen Zuleitung zugeführt werden. Allerdings ist auch bei solch einer denkbaren Verbesserung bei beiden Verbindungspartnern die Lotmenge aus technischen Gründen begrenzt. Dadurch kann speziell unter ungünstigen Umständen die erforderliche Lotmenge nicht erreicht werden. Infolgedessen können insbesondere die mechanische Haftfestigkeit und die elektrische Stromtragfähigkeit, vor allem über die Lebensdauer des Bauteils, beeinträchtigt werden. Dies kann zum vorzeitigen Ausfall des Bauteils im Betrieb führen, beispielsweise durch Dekontaktierung des Anschlusspins. Solche Ausfälle stellen ein erhebliches Qualitätsrisiko dar.

### Offenbarung der Erfindung

Die erfindungsgemäße Außenelektrode mit den Merkmalen des Anspruchs 1, das piezokeramische Vielschichtbauteil mit den Merkmalen des Anspruchs 6 und das Brennstoffeinspritzventil mit den Merkmalen des Anspruchs 8 haben demgegenüber den Vorteil, dass eine verbesserte Ausgestaltung ermöglicht ist und insbesondere eine Zuverlässigkeit der elektrischen Leistungsübertragung und der mechanischen Haftung verbessert sind.

Durch die in den Unteransprüchen aufgeführten Maßnahmen sind vorteilhafte Weiterbildungen der im Anspruch 1 angegebenen Außenelektrode, des im Anspruch 6 angegebenen piezokeramischen Vielschichtbauteils und des im Anspruch 8 angegebenen Brennstoffeinspritzventils möglich.

Durch den vorgegebenen Lotüberschuss im Verbindungsbereich kann die bei den Verbindungspartnern selbst aus technischen Gründen begrenzte Lotmenge ergänzt werden. Dadurch kann auch unter ungünstigen Umständen die erforderliche Lotmenge erreicht werden. Infolgedessen können insbesondere die mechanische Haftfestigkeit und die elektrische Stromtragfähigkeit verbessert und über die Lebensdauer des Bauteils aufrechterhalten werden.

In vorteilhafter Weise ist an dem Verbindungsbereich zumindest zwischen der ersten leitenden Lage und der zweiten leitenden Lage ein Lotüberschuss vorgegeben. Speziell ist es vorteilhaft, dass an dem Verbindungsbereich zwischen der ersten leitenden Lage und der zweiten leitenden Lage eine Lotfolie vorgesehen ist. Zusätzlich ist an dem Verbindungsbereich zumindest zwischen der ersten leitenden Lage und der zweiten leitenden Lage in vorteilhafter Weise auch eine Lotpaste vorgesehen Somit kann gezielt in dem Verbindungsbereich der Lotüberschuss vorgegeben werden.

Vorteilhaft ist es ferner, dass der Verbindungsbereich an einem Endabschnitt vorgesehen ist und dass die zweite leitende Lage eine Aussparung aufweist, die zwischen dem Endabschnitt und einem mittleren Abschnitt vorgesehen ist. Durch solch eine Aussparung kann während dem Schweißen ein Abfließen von Lot in den mittleren Abschnitt verhindert oder zumindest verringert werden. Durch die Aussparung wird somit eine Lotflussunterbrechung während des Herstellungsprozesses erzielt, die den Abfluss des eingestellten Lotüberschusses in die angrenzenden Bereiche verhindert.

Vorteilhaft ist es, dass die erste leitende Lage und die zweite leitende Lage über zumindest einen Biegefalz miteinander verbunden sind. Ferner ist es vorteilhaft, dass die erste leitende Lage und die zweite leitende Lage gewebeartig ausgestaltet sind. Somit kann ausgehend von einer geeignet ausgeformten beziehungsweise zugeschnittenen Schicht durch Biegen die Ausgestaltung der Außenelektrode erfolgen. Über den Biegefalz ist hierbei eine zuverlässige elektrische Verbindung zwischen den Lagen realisiert. Ferner wird über die gewebeartige Struktur zum einen das Biegen ermöglicht und zum anderen im Betrieb ein Längenausgleich bei Dehnungen des piezokeramischen Materials des Vielschichtbauteils ermöglicht.

Speziell ist es hierbei vorteilhaft, dass die erste leitende Lage und die zweite leitende Lage so aus einem gebogenen Drahtgewebe gebildet sind, dass ein mittiger Spalt zwischen dem Biegefalz und einem weiteren Biegefalz gebildet ist, der parallel zu den Biegefalzen verläuft. Die Kontaktierung der Zuleitung, insbesondere eines Pins beziehungsweise Anschlussdrahts, auf das mehrlagige, insbesondere doppellagige, Außenelektrodensieb, also das Drahtgewebe der Außenelektrode, kann hierdurch beispielsweise im fußseitigen Bereich des Vielschichtbauteils in der Mittelachse erfolgen. Das Fügen der Zuleitung auf das Außenelektrodensieb kann hierbei auf einem Spaltschweißen basieren.

Bei der Ausgestaltung des piezokeramischen Vielschichtbauteils kann somit die durch Schweißen gebildete stoffschlüssige Verbindung zwischen der Zuleitung und der ersten leitenden Lage durch ein Lot, das zumindest teilweise aus dem Lotüberschuss im Verbindungsbereich stammt, ergänzt werden. Somit können insbesondere die mechanische Haftfestigkeit und die elektrische Stromtragfähigkeit über die Lebensdauer des piezokeramischen Vielschichtbauteils gewährleistet werden.

Die sich für das piezokeramische Vielschichtbauteil ergebenden Vorteile können somit in vorteilhafter Weise bei einem Brennstoffeinspritzventil genutzt werden, bei dem der piezoelektrische Aktor durch ein vorteilhaft ausgestaltetes piezokeramisches Vielschichtbauteil realisiert ist.

Kurze Beschreibung der Zeichnungen

Bevorzugte Ausführungsbeispiele der Erfindung sind in der nachfolgenden Beschreibung anhand der beigefügten Zeichnungen, in denen sich entsprechende Elemente mit übereinstimmenden Bezugszeichen versehen sind, näher erläutert. Es zeigen:
Fig. 1 ein Brennstoffeinspritzventil mit einem piezokeramischen Vielschichtbauteil in einer auszugsweisen, schematischen Darstellung entsprechend einem ersten Ausführungsbeispiel der Erfindung;
Fig. 2 das in Fig. 1 gezeigte piezokeramische Vielschichtbauteil des Brennstoffeinspritzventils in einer auszugsweisen, schematischen Schnittdarstellung entlang der mit II bezeichneten Schnittlinie entsprechend dem ersten Ausführungsbeispiel der Erfindung;
Fig. 3 eine Außenelektrode für das in Fig. 1 gezeigte piezokeramische Vielschichtbauteil des Brennstoffeinspritzventils entsprechend dem ersten Ausführungsbeispiel der Erfindung in einer schematischen Darstellung;
Fig. 4 einen schematischen Schnitt durch die in Fig. 3 dargestellte Außenelektrode entlang der mit IV bezeichneten Schnittlinie entsprechend dem ersten Ausführungsbeispiel der Erfindung;
Fig. 5 einen schematischen Schnitt durch die in Fig. 3 dargestellte Außenelektrode entlang der mit V bezeichneten Schnittlinie entsprechend dem ersten Ausführungsbeispiel der Erfindung;
Fig. 6 eine Außenelektrode für das in Fig. 1 gezeigte piezoelektrische Vielschichtbauteil des Brennstoffeinspritzventils entsprechend einem zweiten Ausführungsbeispiel der Erfindung in einer schematischen Darstellung;
Fig. 7 einen schematischen Schnitt durch die in Fig. 6 dargestellte Außenelektrode entlang der mit VII bezeichneten Schnittlinie entsprechend dem zweiten Ausführungsbeispiel der Erfindung und
Fig. 8 ein Drahtgewebe zur Herstellung der Außenelektrode entsprechend dem zweiten Ausführungsbeispiel der Erfindung.

Ausführungsformen der Erfindung

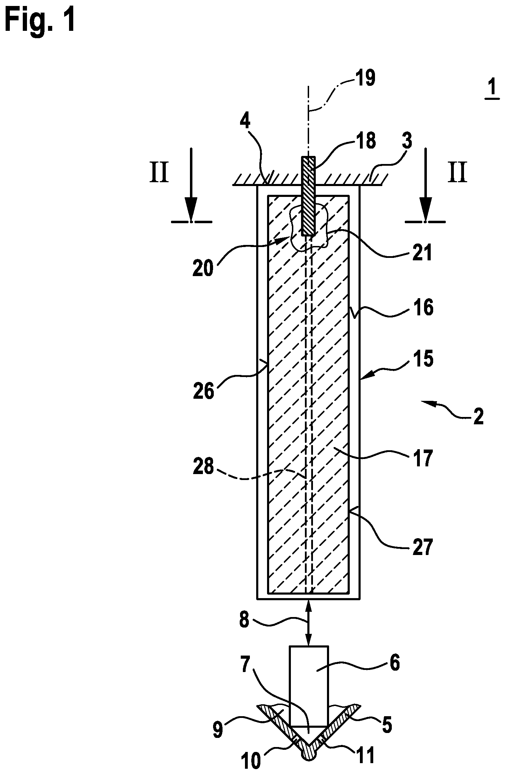

Fig. 1 zeigt ein Brennstoffeinspritzventil 1 mit einem piezokeramischen Vielschichtbauteil 2, das als piezoelektrischer Aktor 2 ausgestaltet ist, in einer auszugsweisen, schematischen Darstellung entsprechend einem ersten Ausführungsbeispiel. Das Brennstoffeinspritzventil 1 kann beispielsweise zur direkten Einspritzung von Brennstoff in den Brennraum einer Brennkraftmaschine dienen. Hierbei kann das Brennstoffeinspritzventil 1 insbesondere für luftverdichtende, selbstzündende Brennkraftmaschine und gemischverdichtende, fremdgezündete Brennkraftmaschinen zum Einsatz kommen.

Das piezoelektrische Vielschichtbauteil 2 eignet sich auch für andere Anwendungsfälle. Hierbei kann das piezoelektrische Vielschichtbauteil 2 als piezoelektrischer Aktor 2 dienen. Allerdings kann das piezoelektrische Vielschichtbauteil 2 auch als piezoelektrischer Sensor 2 dienen.

Das Brennstoffeinspritzventil 1 weist ein Gehäuseteil 3 auf, an dem sich der piezoelektrische Aktor 2 mit seinem Aktorfuß 4 abstützt. Ferner ist ein Düsenkörper 5 vorgesehen, in dem eine Düsennadel 6 mit einem Ventilschließkörper 7 angeordnet ist. Die Düsennadel 6 ist zumindest mittelbar von dem Aktor 2 ansteuerbar, was schematisch durch einen Doppelpfeil 8 veranschaulicht ist.

Bei einer Betätigung der Düsennadel 6 wird ein zwischen dem Ventilschließkörper 7 und dem Düsenkörper 5 gebildeter Dichtsitz geöffnet, so dass Brennstoff aus einem Brennstoffraum 9 im Inneren des Düsenkörpers 5 über Spritzlöcher 10, 11 beispielsweise in den Brennraum einer Brennkraftmaschine eingespritzt werden kann.

Der piezoelektrische Aktor 2 weist einen als Aktorkörper 15 ausgestalteten Körper 15 auf. Der Aktorkörper 15 weist eine Vielzahl von keramischen Schichten und eine Vielzahl von zwischen den keramischen Schichten angeordneten Innenelektrodenschichten auf. An einer Außenseite 16 des Aktorkörpers 15 ist eine Außenelektrode 17 angebracht, die mit einem Teil der Innenelektrodenschichten elektrisch kontaktiert ist. Ferner ist eine elektrische Zuleitung 18 für die Außenelektrode 17 vorgesehen. Die elektrische Zuleitung 18 ist mit der Außenelektrode 17 verbunden. Entsprechend ist eine weitere Außenelektrode vorgesehen, die beispielsweise an einer von der Außenseite 16 abgewandten weiteren Außenseite des Aktorkörpers 15 angebracht ist. Diese weitere Außenelektrode ist mit einer weiteren elektrischen Zuleitung verbunden. Über die weitere Außenelektrode können die anderen Innenelektrodenschichten elektrisch kontaktiert werden. Allerdings sind auch andere Ausgestaltungen denkbar. Beispielsweise kann die Kontaktierung der anderen Innenelektrodenschichten, die nicht von der Außenelektrode 17 kontaktiert sind, auch über eine geeignete Innenelektrode realisiert werden, die sich entlang einer Längsachse 19 durch den Aktorkörper 15 erstreckt.

Das piezokeramische Vielschichtbauteil 2, insbesondere der piezoelektrische Aktor 2, weist somit zumindest eine Außenelektrode 17 auf, die über eine elektrische Zuleitung 18 mit einer geeigneten Einrichtung, insbesondere einem Steuergerät, verbunden ist.

Die elektrische Zuleitung 18 ist in einem Verbindungsbereich 20 durch Schweißen stoffschlüssig mit der Außenelektrode 17 verbunden. Hierbei ist an dem Verbindungsbereich 20 ein Lotüberschuss 21 vorgegeben. Durch den Lotüberschuss 21 wird die Schweißverbindung durch vorhandenes Lot ergänzt und verbessert. Dadurch verbessert sich die Zuverlässigkeit der elektrischen Leistungsübertragung. Ferner kann die mechanische Haftung verbessert werden.

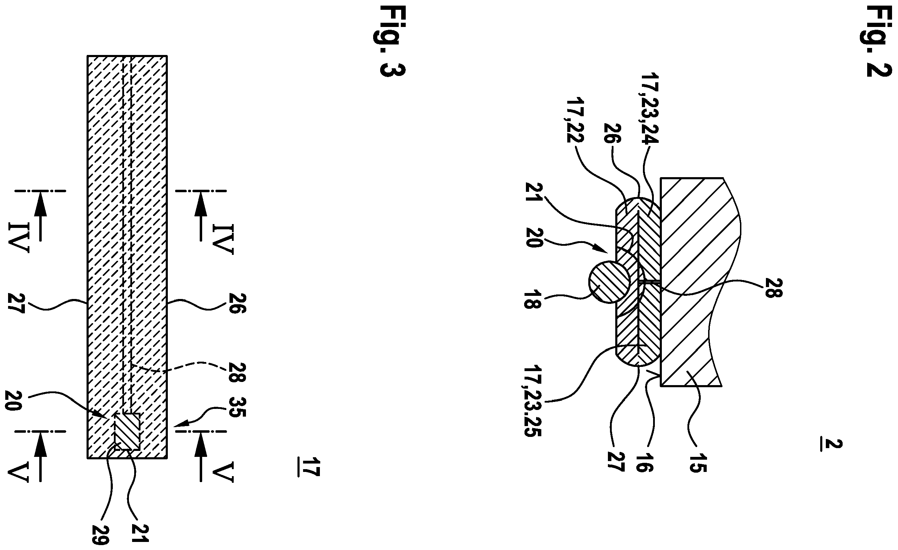

Fig. 2 zeigt das in Fig. 1 dargestellte piezokeramische Vielschichtbauteil 2 des Brennstoffeinspritzventils 1 in einer auszugsweisen, schematischen Schnittdarstellung entlang der mit II bezeichneten Schnittlinie. Die Außenelektrode 17 weist eine erste leitende Lage 22 und eine zweite leitende Lage 23 auf. Bei einer abgewandelten Ausgestaltung können auch weitere leitende Lagen vorgesehen sein.

Die zweite leitende Lage 23 weist in diesem Ausführungsbeispiel Streifen 24, 25 auf, die über Biegefalze 26, 27 mit der ersten leitenden Lage 22 verbunden sind. Hierbei ist zwischen den Biegefalzen 26, 27 beziehungsweise zwischen den Streifen 24, 25 ein mittiger Spalt 28 gebildet, der entlang der Längsachse 19 und somit parallel zu den Biegefalzen 26, 27 verläuft. Die Außenelektrode 17 kann hierdurch in vorteilhafter Weise beispielsweise aus einem gebogenen Drahtgewebe gebildet sein.

Die elektrische Zuleitung 18 ist im Verbindungsbereich 20 mittig zwischen den Biegefalzen 26, 27 positioniert und liegt somit im Bereich des mittigen Spaltes 28 der zweiten leitenden Lage 23. Durch den Lotüberschuss 21 im Verbindungsbereich 20 wird die Schweißverbindung auch dahingehend verbessert, dass Geometrie- und Lagetoleranzen bezüglich der vorgegebenen Position der elektrischen Zuleitung 18 im Verbindungsbereich 20 relativ zu dem mittigen Spalt (Siebspalt) 28 ermöglicht werden, ohne dass es zu wesentlichen Eigenschaftssteuerungen der Fügeverbindung kommt.

Fig. 3 zeigt die Außenelektrode 17 für das in Fig. 1 gezeigte elektrische Vielschichtbauteil 2 des Brennstoffeinspritzventils 1 entsprechend dem ersten Ausführungsbeispiel der Erfindung in einer schematischen Darstellung. Hierbei ist die Außenelektrode 17 vor der

Ausgestaltung der Schweißverbindung mit der Zuleitung 18 dargestellt. Der Lotüberschuss 21 wird in diesem Ausführungsbeispiel dadurch realisiert, dass zwischen der ersten leitenden Lage 22 und der zweiten leitenden Lage 23 eine Lotfolie 29 angeordnet wird. Die Lotfolie 29 wird hierbei in dem Verbindungsbereich 20 positioniert, indem die Verbindung mit der elektrischen Zuleitung 18 ausgestaltet wird. Dadurch ist an dem Verbindungsbereich 20 zwischen den leitenden Lagen 22, 23 der Lotüberschuss 21 vorgegeben.

Bei einer abgewandelten Ausgestaltung kann an dem Verbindungsbereich 20 zwischen der ersten leitenden Lage 22 und der zweiten leitenden Lage 23 auch eine Lotpaste 29 vorgesehen sein. Denkbar ist auch eine Kombination aus Lotfolie 29 und Lotpaste 29, die im Verbindungsbereich 20 zwischen die leitenden Lagen 22, 23 eingebracht werden.

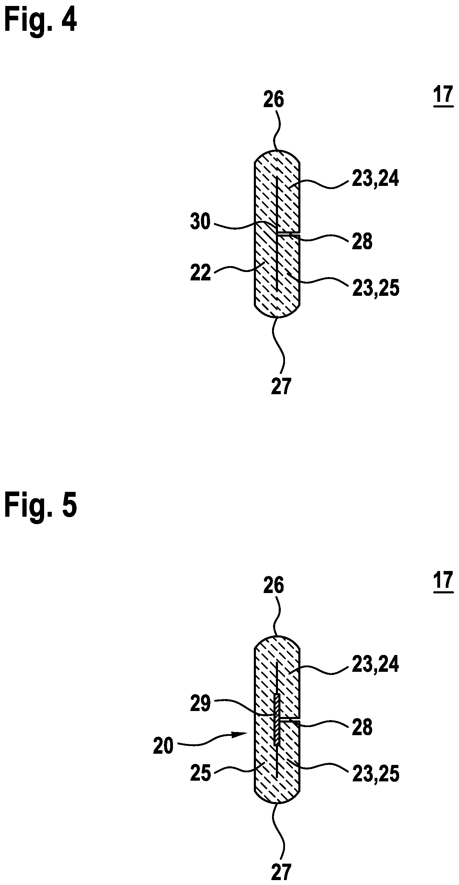

Fig. 4 zeigt einen schematischen Schnitt durch die in Fig. 3 dargestellte Außenelektrode 17 entlang der mit IV bezeichneten Schnittlinie entsprechend dem ersten Ausführungsbeispiel. Hierbei ist die Ausgestaltung der Außenelektrode 17 außerhalb des Verbindungsbereichs 20 veranschaulicht. Die leitenden Lagen 22, 23 liegen hierbei direkt aneinander an. Insbesondere sind die Streifen 24, 25 der zweiten leitenden Lage 23 vorzugsweise so umgebogen, dass diese auch in einem mittleren Bereich 30 an der ersten leitenden Lage 22 anliegen.

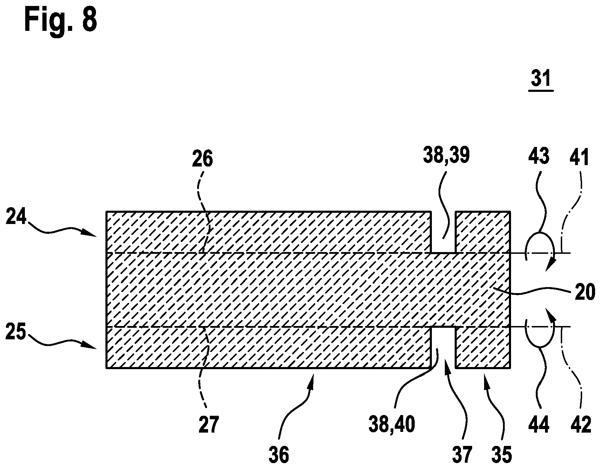

Fig. 5 zeigt einen schematischen Schnitt durch die in Fig. 3 dargestellte Außenelektrode entlang der mit V bezeichneten Schnittlinie entsprechend dem ersten Ausführungsbeispiel. Hierbei ist die Ausgestaltung der Außenelektrode 17 im Verbindungsbereich 20 veranschaulicht. Zwischen den Lagen 22, 23 ist die Lotfolie 29 eingebracht. Die Lotfolie 29 befindet sich hierbei vorzugsweise mittig zwischen den Biegefalzen 26, 27 an dem mittigen Spalt 28. Die Lotfolie 29 ist somit lokal in eingebogenes Drahtgewebe 31 (Fig. 8), aus dem die Lagen 22, 23 gebildet sind, eingefaltet.

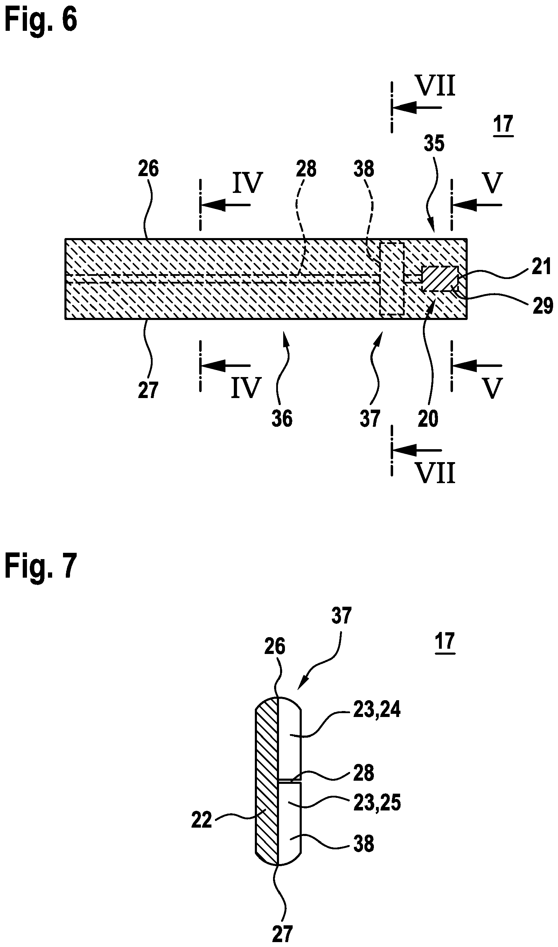

Fig. 6 zeigt eine Außenelektrode 17 für das in Fig. 1 gezeigte piezokeramische Vielschichtbauteil 2 des Brennstoffeinspritzventils 1 entsprechend einem zweiten Ausführungsbeispiel. Der Verbindungsbereich 20 ist hierbei in einem Endabschnitt 35 der Außenelektrode 17 vorgesehen. Die Ausgestaltung im Endabschnitt 35, insbesondere im Verbindungsbereich 20, entspricht dabei dem ersten Ausführungsbeispiel, wie es durch den mit V bezeichneten Schnitt illustriert ist. Ferner entspricht auch die Ausgestaltung in einem mittleren Abschnitt 36 der Außenelektrode 17 dem ersten Ausführungsbeispiel, wie es durch den mit IV bezeichneten Schnitt veranschaulicht ist. Die mit IV und V bezeichneten Schnitte sind somit in den Fig. 4 und 5 dargestellt.

Allerdings weist die Außenelektrode 17 in einem Abschnitt 37, der zwischen dem Endabschnitt 35 und dem mittleren Abschnitt 36 liegt, eine Aussparung 38 auf. Die Aussparung 38 ist somit zwischen dem Endabschnitt 35 und dem mittleren Abschnitt 36 vorgesehen. Die Aussparung 38 ist zumindest in der zweiten leitenden Lage 23 der Außenelektrode 17 ausgestaltet. In diesem Ausführungsbeispiel ist die Aussparung 38 nur in der zweiten leitenden Lage 23 ausgestaltet.

Fig. 7 zeigt einen schematischen Schnitt durch die in Fig. 6 dargestellte Außenelektrode 17 entlang der mit VII bezeichneten Schnittlinie entsprechend dem zweiten Ausführungsbeispiel. Hierbei ist in den Streifen 24, 25 die Aussparung 38 vorgesehen, so dass die Streifen 24, 25 in dem Abschnitt 37 unterbrochen sind.

Durch die Aussparung 38 wird eine einlagig freigelegte Lotflussunterbrechung 38 nahe dem Verbindungsbereich 20 gebildet. Während der Ausbildung der Schweißverbindung zwischen der Außenelektrode 17 und der Zuleitung 18 wird dadurch ein Abfließen des Lotüberschusses 21 in den mittleren Abschnitt 36 verhindert oder zumindest verringert. Somit steht der Lotüberschuss 21 weitgehend zur Verbesserung der Schweißverbindung zur Verfügung.

Fig. 8 zeigt ein Drahtgewebe 31 zur Herstellung der Außenelektrode 17 entsprechend dem zweiten Ausführungsbeispiel in einer schematischen Darstellung. Das Drahtgewebe 31 weist in dem Abschnitt 37 seitliche Einschnitte 39, 40 auf. Die seitlichen Einschnitte 39, 40 sind hierbei in den Streifen 24, 25 ausgebildet. Anschließend werden die Streifen 24, 25 um Biegeachsen 41, 42 gebogen, wodurch die Biegefalze 26, 27 ausgestaltet werden. Die seitlichen Einschnitte 39, 40 bilden dann die Aussparung 38. Das Umbiegen ist durch Pfeile 43, 44 veranschaulicht. Die Lotfolie 29 beziehungsweise eine Lotpaste 29 wird vor dem Umbiegen in dem Verbindungsbereich 20 am Endabschnitt 35 so positioniert, dass die anhand der Fig. 5 veranschaulichte Position im gebogenen Drahtgewebe 31 erreicht wird.

Somit können die leitenden Lagen 22, 23 aus dem gebogenen Drahtgewebe 31 gebildet werden, wobei der mittige Spalt 28 entsteht.

Durch das gebogene Drahtgewebe 31 kann ein doppellagiges Außenelektrodensieb 31 gebildet werden. Allerdings können auch mehr als zwei Lagen vorgesehen sein. Somit kann ein Design für die Außenelektrode 17 mit einer Fügeprozess optimierten, lokal angepassten Lotmenge, insbesondere dem Lotüberschuss 21, für eine gleich bleibende Qualität bei einer späteren Pin-Kontaktierung bereitgestellt werden. Somit kann eine ausreichende Lotmenge zur Verfügung gestellt werden, um die Schweißverbindung mit der Zuleitung 18 zu bilden, wodurch ein vorzeitiger Bauteilausfall verhindert ist. Der Lotüberschuss 21 kann hierbei insbesondere durch einen Zinneintrag in Form der Lotfolie 29 und/oder der Lotpaste 29 erzielt werden. Die Qualität der späteren Kontaktierung wird dadurch entscheidend verbessert, was insbesondere in Kombination mit der Lotflussunterbrechung, die durch die Aussparung 38 gebildet ist, möglich ist.

Die Erfindung ist nicht auf die beschriebenen Ausführungsbeispiele beschränkt.

## Patentansprüche

1. Außenelektrode (17) für ein Vielschichtbauteil (2) mit einer ersten leitenden Lage (22) und zumindest einer zweiten leitenden Lage (23), wobei die erste leitende Lage (22) einen Verbindungsbereich (20) aufweist, in dem eine Zuleitung (18) durch Schweißen stoffschlüssig mit zumindest der ersten leitenden Lage (22) verbindbar ist, **dadurch gekennzeichnet, dass** an dem Verbindungsbereich (20) ein Lotüberschuss (21) vorgegeben ist und an dem Verbindungsbereich (20) zumindest zwischen der ersten leitenden Lage (22) und der zweiten leitenden Lage (23) der Lotüberschuss (21) vorgegeben ist und an dem Verbindungsbereich (20) zwischen der ersten leitenden Lage (22) und der zweiten leitenden Lage (23) zumindest eine Lotfolie (29) vorgesehen ist.

2. Außenelektrode nach Anspruch 1,
**dadurch gekennzeichnet,**
**dass** der Verbindungsbereich (20) an einem Endabschnitt (35) vorgesehen ist und dass zumindest die zweite leitende Lage (23) eine Aussparung (38) aufweist, die zwischen dem Endabschnitt (35) und einem mittleren Abschnitt (36) vorgesehen ist.

3. Außenelektrode nach einem der Ansprüche 1 bis 2,
**dadurch gekennzeichnet,**
**dass** die erste leitende Lage (22) gewebeartig ausgestaltet ist und/oder dass die zweite leitende Lage (23) gewebeartig ausgestaltet ist.

4. Außenelektrode nach einem der Ansprüche 1 bis 3,
**dadurch gekennzeichnet,**
**dass** die erste leitende Lage (22) und die zweite leitende Lage (23) über zumindest einen Biegefalz (26, 27) miteinander verbunden sind.

5. Außenelektrode nach Anspruch 4,
**dadurch gekennzeichnet,**
**dass** die erste leitende Lage (22) und die zweite leitende Lage (23) so aus einem gebogenen Drahtgewebe (31) gebildet sind, dass ein mittiger Spalt (28) zwischen dem Biegefalz (26) und einem weiteren Biegefalz (27) gebildet ist, der parallel zu den Biegefalzen (26, 27) verläuft.

6. Piezokeramisches Vielschichtbauteil (2), insbesondere piezokeramischer Aktor (2), mit einer Außenelektrode (17), nach Anspruch 1.

7. Piezokeramisches Vielschichtbauteil nach Anspruch 6,
**dadurch gekennzeichnet,**
**dass** die durch Schweißen gebildete stoffschlüssige Verbindung zwischen der Zuleitung (18) und der ersten leitenden Lage (22) durch ein Lot, das zumindest teilweise aus dem Lotüberschuss (21) im Verbindungsbereich (20) stammt, ergänzt ist.

8. Brennstoffeinspritzventil (1), insbesondere Injektor für Brennkraftmaschinen, mit einem piezokeramischen Vielschichtbauteil (2) nach Anspruch 6 oder 7, das als piezoelektrischer Aktor (2) ausgestaltet ist.

## Claims

1. External electrode (17) for a multi-layer component (2) having a first conductive layer (22) and having at least one second conductive layer (23), wherein the first conductive layer (22) has a connection region (20) in which a feed line (18) can be cohesively connected, by welding, to at least the first conductive layer (22), **characterized in that**, at the connection region (20), a solder surplus (21) is predefined and, at the connection region (20), the solder surplus (21) is predefined at least between the first conductive layer (22) and the second conductive layer (23), and, at the connection region (20), at least one solder foil (29) is provided between the first conductive layer (22) and the second conductive layer (23).

2. External electrode according to Claim 1,
**characterized**
**in that** the connection region (20) is provided at an end section (35), and in that at least the second conductive layer (23) has a cutout (38) which is provided between the end section (35) and a central section (36).

3. External electrode according to either of Claims 1 and 2,
**characterized**
**in that** the first conductive layer (22) is formed in the manner of a fabric and/or in that the second conductive layer (23) is formed in the manner of a fabric.

4. External electrode according to one of Claims 1 to 3,
**characterized**
**in that** the first conductive layer (22) and the second conductive layer (23) are connected to one another by way of at least one bending fold (26, 27).

5. External electrode according to Claim 4,
**characterized**
**in that** the first conductive layer (22) and the second conductive layer (23) are formed from a bent wire fabric (31) such that a central gap (28) is formed between the bending fold (26) and a further bending fold (27), which central gap runs parallel to the bending folds (26, 27).

6. Piezoceramic multi-layer component (2), in particular piezoceramic actuator (2), having an external electrode (17) according to Claim 1.

7. Piezoceramic multi-layer component according to Claim 6,
**characterized**
**in that** the cohesive connection, formed by welding, between the feed line (18) and the first conductive layer (22) is supplemented by a solder which originates at least partially from the solder surplus (21) in the connection region (20).

8. Fuel injection valve (1), in particular injector for internal combustion engines, having a piezoceramic multi-layer component (2) according to Claim 6 or 7 which is in the form of a piezoelectric actuator (2).

## Revendications

1. Électrode extérieure (17) pour un composant multicouche (2) comprenant une première couche conductrice (22) et au moins une deuxième couche conductrice (23), la première couche conductrice (22) possédant une zone de liaison (20) dans laquelle une ligne d'arrivée (18) peut être reliée par fusion de matières par soudage au moins avec la première couche conductrice (22), **caractérisée en ce qu'**il est prévu un excès de soudure (21) au niveau de la zone de liaison (20) et **en ce que** l'excès de soudure (21) est prédéterminé au niveau de la zone de liaison (20) au moins entre la première couche conductrice (22) et la deuxième couche conductrice (23) et **en ce qu'**il est prévu au moins une feuille de soudure (29) entre la première couche conductrice (22) et la deuxième couche conductrice (23) au niveau de la zone de liaison (20).

2. Électrode extérieure selon la revendication 1, **caractérisée en ce que** la zone de liaison (20) est disposée au niveau d'une portion d'extrémité (35) et **en ce qu'**au moins la deuxième couche conductrice (23) possède une cavité (38) qui est prévue entre la portion d'extrémité (35) et une portion centrale (36).

3. Électrode extérieure selon selon l'une des revendications 1 à 2, **caractérisée en ce que** la première couche conductrice (22) est réalisée sous la forme d'un tissu et/ou **en ce que** la deuxième couche conductrice (23) est réalisée sous la forme d'un tissu.

4. Électrode extérieure selon l'une des revendications 1 à 3, **caractérisée en ce que** la première couche conductrice (22) et la deuxième couche conductrice (23) sont liées l'une à l'autre par l'intermédiaire d'au moins une pliure (26, 27).

5. Électrode extérieure selon la revendication 4, **caractérisée en ce que** la première couche conductrice (22) et la deuxième couche conductrice (23) sont formées à partir d'un tissu de fil métallique (31) de manière à former un interstice central (28) entre la pliure (26) et une autre pliure (27), lequel interstice s'étend parallèlement aux pliures (26, 27).

6. Composant multicouche piézocéramique (2), notamment actionneur piézocéramique (2), comprenant au moins une électrode extérieure (17) selon la revendication 1.

7. Composant multicouche piézocéramique selon la revendication 6, **caractérisé en ce que** la liaison par fusion de matières formée par soudage entre la ligne d'arivée (18) et la première couche conductrice (22) est complétée par une soudure qui provient au moins en partie de l'excès de soudure (21) dans la zone de liaison (20).

8. Injecteur de combustible (1), notamment injecteur pour moteurs à combustion interne, comprenant un composant multicouche piézocéramique (2) selon la revendication 6 ou 7 qui est réalisé sous la forme d'un actionneur piézoélectrique (2).
